Europäisches Patentamt

European Patent Office

Office européen des brevets

(11) Publication number: **0 262 980 B1**

# EUROPEAN PATENT SPECIFICATION

(45) Date of publication of patent specification: **11.11.92**

(51) Int. Cl.5: **H01L 21/205**, H01L 31/18, C23C 16/24

(21) Application number: **87308751.4**

(22) Date of filing: **02.10.87**

The file contains technical information submitted after the application was filed and not included in this specification

(54) **Method of forming semiconducting amorphous silicon films from the thermal decomposition of dihalosilanes.**

(30) Priority: **03.10.86 US 914898**

(43) Date of publication of application:
**06.04.88 Bulletin 88/14**

(45) Publication of the grant of the patent:
**11.11.92 Bulletin 92/46**

(84) Designated Contracting States:
**DE FR GB IT NL**

(56) References cited:
**EP-A- 0 062 079**
**US-A- 4 409 605**
**US-A- 4 485 121**

(73) Proprietor: **DOW CORNING CORPORATION**

**Midland Michigan 48640(US)**

(72) Inventor: **Sharp, Kenneth George**
**1500 Whitehall**
**Midland Michigan(US)**

(74) Representative: **Lewin, John Harvey et al**
**Elkington and Fife Prospect House 8 Pembroke Road**
**Sevenoaks, Kent TN13 1XR(GB)**

Rank Xerox (UK) Business Services

## Description

The present invention relates to the discovery that pyrolysis of certain dihalogenated monosilanes or mixtures of dihalogenated monosilanes can result in the formation of a highly stable, highly abrasion resistant, photoconductive, dopable semiconductor film on a substrate.

Amorphous polymeric materials of silicon and hydrogen (hereafter referred to as a-SiH) have emerged as a new class of semiconductors in recent years. Such materials are described, for example, in D. Carlson, U.S. Patent No. 4,064,521, issued on December 20, 1976. The materials are generated as thin films from the decomposition of silane ($SiH_4$) in electrical discharges or, less frequently, from the thermal decomposition of silane or higher hydrogen-containing silanes (e.g.. $Si_2H_6$, $Si_3H_8$, etc.) as described in a PCT patent application by A. MacDiarmid and Z. Kiss published as International Publication No. WO 82/03069 dated September 16, 1982.

When it is desirable to include additional elemental constituents in the amorphous films, co-reactants such as phosphine ($PH_3$) or diborane ($B_2H_6$) are added to the starting materials. When fluorine is to be incorporated into an amorphous film, tetrafluorosilane ($SiF_4$) is most commonly added to the reactant mixture. This is described, for example, in U.S. Patent No. 4,217,374 granted to Ovshinsky and Izu on August 12, 1980. Similarly, chlorine atoms can be incorporated into films via decomposition of mixtures of silicon tetrachloride ($SiCl_4$) and silane or hydrogen (see, for example, V. Augelli and R. Murri, Mater. Chem. and Phys. (Switzerland) 9, 301-5 (1983)).

A disadvantage to the use of silane, disilanes or polysilanes ($Si_nH_{2n+2}$) as a starting material for generation of a -SiH relates to the high explosion hazard of silane/air mixtures. An operational consequence of this explosion hazard is the frequent use of inert carrier gases as diluents in these systems. Both discharge (plasma) and chemical vapor deposition (CVD) routes to a-SiH from silane also have disadvantageous features. Conventional discharge systems require relatively sophisticated and expensive equipment to remove the reaction by-products. Silane-based CVD systems, while simple, suffer from a tendency to undergo vapor nucleation unless the pressure is very low. This behavior restricts the range of permissible operating conditions for such thermal decompositions.

United Kingdom Patent No. 2,148,328, issued to M. Hirooka et al., on May 30, 1985, teaches the decomposition of various silanes, including halosilanes ($SiX_4$), cyclic polymeric halosilanes ($SiX_2)_n$, where n is greater than or equal to 3, di- and polysilanes such as $Si_nHX_{2n+1}$ and $Si_nH_2X_{2n}$.

These materials are decomposed via electric discharge, photolysis, high temperature or catalytically and mixed with a requisite second stream consisting of a vapor phase material selected from the group consisting of $H_2$, $SiH_4$, $SiH_3Br$, or $SiH_3I$ wherein the second stream has also been decomposed. The obvious disadvantage of such prior art, one which clearly distinguishes it from the instant invention, is the necessity of having two materials to decompose. Hirooka et al. requires the second stream as the source of hydrogen to facilitate the reduction of the halosilane to the amorphous silicon. The instant invention, however, has sufficient hydrogen in the single component dihalomonosilane to produce the desired amorphous silicon film. Several of the molecular precursors claimed by Hirooka et al., such as $(SiH_2)_3$ or $(SiX_2)_3$, where X = F or Cl have either not been reported as being prepared elsewhere in the literature or have proved exceedingly difficult to synthesize. Hirooka et al., does not teach the synthesis of these elusive molecules.

United Kingdom Patent number 2,156,385, issued October 9, 1985 to Tanaka et al., teaches the deposition of a silicon film on a heated substrate from a reactant fluorosilane gas in the plasma state. However, Tanaka et al. does not teach the use of chemical vapor deposition of dihalosilanes to form amorphous silicon-containing films.

Thus, the instant invention is distinguished from prior art utilizing chemical vapor deposition of disilanes, polysilanes, and reduction systems requiring dual streams of starting materials. The instant invention is also distinguished from the prior art utilizing plasma deposition systems.

The present invention relates to the formation of amorphous silicon films prepared from the thermal decomposition, often referred to as chemical vapor deposition (CVD), of dihalosilanes. By "dihalosilane" herein is meant a monosilane compound in which the silicon atom has bonded to it two halogen atoms and two hydrogen atoms. The term "amorphous" is herein construed to include both noncrystalline and microcrystalline materials, in which the crystallites are less than 5 nm (50 Ångstroms) in dimension, and are not contiguous so as to form well defined grain boundaries. The films are formed from decomposition of vapor phase dihalomonosilanes, $X_2SiH_2$, in a sealed decomposition vessel at elevated temperatures. No additional source of hydrogen is needed in the instant invention nor is the use of electric discharges (plasma) necessary. The dihalosilane starting material provides an important purification capability over that of disilane (or higher molecular weight) starting materials. Siloxane impurities in the disilane (and higher) starting materials of the prior art can introduce unacceptably high amounts of oxygen into the film being deposited. Siloxane impurities are easily removed from dihalomonosilanes. It should also be noted that tetrahalomonosilanes such as tetrachloro- or tetrafluorosilane and the corresponding trihalosilanes cannot be employed as starting materials in the decomposition to provide satisfactory films according to the invention. The instant invention also simplifies the feed process of the material to be decomposed by reducing the number of reactants from two to one since an additional source of hydrogen is not required. The hydrogen initially on the dihalosilane results in silicon-hydrogen bonds in the film, said silicon-hydrogen bonds being known in the art to be associated with a lowering of the defect density in the amorphous silicon film.

The instant invention relates to a method of forming amorphous polymeric silicon-containing films on a substrate which method comprises decomposing a dihalosilane or mixture of dihalosilanes in the vapor phase wherein the halogens of the dihalosilane or mixture of dihalosilanes are independently chosen from the group consisting of fluorine, chlorine, bromine, and iodine, at a temperature between 400 degrees and 600 degrees Centigrade in a reaction chamber containing a substrate which is thermally and chemically stable at the decomposition temperature in the atmosphere of the reaction chamber, whereby said films are formed on said substrate. A preferred temperature range for the thermal decomposition of the instant invention is between 450 and 570 degrees Centigrade.

The instant invention features the further advantage that the dihalomonosilanes utilized are not susceptible to vapor nucleation at higher pressures. When amorphous silicon-containing films are generated from silane, care must be taken to limit the system pressure so as to avoid formation of particulates in the vapor phase, with consequent degradation of the deposited material.

A further aspect of the claimed method is the formation of electronic, electro-optical, and photovoltaic devices including, for example, solar cells, thin film transistors, or optical data storage media, as well as corrosion resistant coatings, abrasion resistant coatings and devices and articles derived therefrom. A variety of possible devices based on amorphous silicon-containing films derived from the instant invention will be apparent to those skilled in the art.

The instant invention produces semiconducting, dopable, air-stable silicon-containing amorphous films from the thermal decomposition of dihalosilanes. The films produced by the instant invention exhibit strong adhesion to substrates, are abrasion resistant, are stable at elevated temperatures, and are strong absorbers of visible light.

Dihalosilanes, such as difluorosilane, $H_2SiF_2$ and/or dichlorosilane, $H_2SiCl_2$, are placed in an evacuated glass or metal container along with a substrate to be coated with an amorphous silicon film. The reactor vessel material is not limited to glass or metal but can be any container material able to withstand the temperature and reduced pressure conditions of the CVD process. The choice of substrates is limited only by the need for thermal and chemical stability at the decomposition temperature in the atmosphere of the decomposition vessel. Thus, the substrate to be coated can be, for example, various types of glass, metals, such as steel and aluminum, plastics able to withstand the reaction temperatures, and ceramic materials, such as aluminum oxide, silicon nitride, and silicon oxynitride.

In the simplest implementation, a glass ampoule serves as the reaction vessel. Both the reaction vessel and substrate are first cleaned (e.g., in an alkaline detergent) and rinsed with a highly purified solvent, preferably water or "electronic grade" methanol. The reaction vessel is then attached to a vacuum line, the contents evacuated, and the vessel thoroughly heated under vacuum with, for example, a gas-oxygen torch. The dihalosilane is transferred to the reaction vessel in such a manner as to preclude exposure to the atmosphere. The reaction vessel is sealed with a natural gas-oxygen torch and heated in an oven or furnace for a time generally in the range of 10 to 90 minutes at a temperature in the range of from 400 degrees Centigrade to 600 degrees Centigrade and preferably in the range of from 450 degrees Centigrade to 570 degrees Centigrade. During this time, the starting material decomposes and forms a silicon film on the substrate. Then the reaction by-products, trihalosilane and hydrogen (and any unreacted starting material if present), may conveniently be removed by evacuation after the reaction vessel has been reattached to the vacuum line. The substrate, onto which the decomposed dihalosilane starting material has deposited an amorphous silicon film, is then removed. By this method, difluorosilane and dichlorosilane have been thermally decomposed in the vapor phase to deposit amorphous silicon films on various substrates. The resulting coatings are reflective, air-stable, abrasion resistant, moisture resistant, photoconductive, semiconductive amorphous silicon-containing films.

Alternate modes of film production are available in an all metal high vacuum reactor. The reaction vessel is constructed from stainless steel and features a turbomolecular pump so as to provide oil-free operation, precise pressure control and multiple reactant inlet channels. Dihalomonosilanes are decomposed under static (no-flow) conditions. The reactor is evacuated to less than $0.13 \times 10^{-3}$ Pa ($10^{-6}$ Torr) and power to the substrate heater supplied so as to bring the temperature of the surface of the desired substrate into the range 400-600 °Centigrade. For the static depositions, the region of the reactor proximal to the substrate is charged with the reactant gas and any desired dopant to a total pressure of from less than 133.3 Pa to 66.7 kPa (1 to 500 Torr), isolated from the pump, and the deposition reaction allowed to proceed for 10 to 90 minutes.

Any unreacted starting materials or byproduct gases are swept from the deposition region with a nitrogen purge into a chemical scrubber unit.

Films produced by the instant invention are useful as semiconducting materials in photovoltaics, passive optical layers, corrosion resistant coatings, hermetic barrier coatings, and abrasion resistant coatings, among other applications obvious to those skilled in the art. Because both the tetrahalosilanes ($X_4Si$) and trihalosilanes ($X_3SiH$), where X is selected from the class consisting of fluorine, chlorine, bromine, and iodine, are not effective thermal sources of amorphous silicon films for these applications without an additional source of hydrogen, the present invention using the dihalomonosilanes is unique and unobvious. Monohalosilanes, such as $SiH_3F$ and $SiH_3Cl$, are difficult to synthesize and are highly susceptible to decomposition through redistribution reactions (see H. Emeleus and A. Maddock, J. Chem. Soc. 1944, 293).

## Example 1 (Variable Temperature Deposition)

Difluorosilane 2.67 kPa (20 Torr) was placed in a cleaned Pyrex ampoule along with a Corning 7059 glass substrate. The ampoule was sealed and heated for 60 minutes at a temperature of 400 degrees Centigrade. At this point, formation of a thin film was apparent in the ampoule. The ampoule was then heated to successively higher temperatures; 30 minutes each at 450° and 475° Centigrade, and 15 minutes each at 500° and 550° Centigrade. The ampoule was then cooled to room temperature and attached to a vacuum line to remove the reaction by-products. The ampoule was broken and the film-coated substrate removed. No evidence of powder formation was apparent. Film thickness was determined by a surface profilometer to be approximately 100 nm (1000 Ångstroms). The film was golden-brown in color, with a high reflectivity.

The dark conductivity of the film was determined to be $1.1 \times 10^{-9}$ Siemens/cm, and the conductivity under AM1 irradiation was $1.1 \times 10^{-7}$ Siemens/cm. A measurement of the temperature dependence of dark conductivity led to an evaluation of the activation energy of 0.785 eV.

## Example 2 (Constant Temperature Deposition)

A film sample was prepared in the manner of Example 1 except that the initial system pressure was 13.3 kPa (100 Torr) and the deposition temperature remained constant at 550 °Centigrade. Analysis of the residual gases in the system after deposition revealed the presence of hydrogen and trifluorosilane along with unreacted difluorosilane. No evidence of vapor nucleation or powder formation existed.

## Example 3 (Metal Reactor)

33.3 kPa (250 Torr) of difluorosilane was placed in the all metal high vacuum reactor in the vicinity of a Corning 7059 glass substrate heated to 500° Centigrade. Deposition was allowed to occur for 90 minutes to give a smooth, shiny, air-stable film whose thickness was estimated to be 80 nm (800 Ångstroms).

## Example 4 (Mechanical properties)

Difluorosilane was coated onto a piece of Corning 7059 glass in the manner of Example 2. Potential of the film for abrasion resisting coating applications was established from the following tests; Military specification test C-675A for optical films was applied to the coating. Commonly referred to as the "eraser test", this is a rigorous test of abrasion resistance for such films. The test produced no perceptible change in the film. Military specification test M-13508 for adhesion was performed on the material. The test produced no change in the film, which is evidence of excellent adhesion to the glass substrate.

A Teledyne-Tabor Shear/Scratch Tester was used to test abrasion resistance. The diamond stylus in the tester was placed under a 10 gram load and dragged across the surface of the film. Virtually no damage to the film was evident on microscopic examination of the surface.

## Example 5 (n-Doped material)

Difluorosilane was coated onto a piece of Corning 7059 glass in the manner of Example 2, except that 1 mole% phosphine ($PH_3$) was added as a gaseous dopant. The resultant film displayed a dark conductivity of $1 \times 10^{-1}$ Siemens/cm and an activation energy of 0.14 eV. These data indicate an increase of eight orders of magnitude in conductivity in the doped material relative to its undoped (intrinsic) counterpart.

## Example 6 (p-Doped material)

Difluorosilane was coated onto a piece of Corning 7059 glass in the manner of Example 2, except that 1 mole% diborane ($B_2H_6$) was added as a gaseous dopant, and the system pressure and temperature were 6.67 kPa (50 Torr) and 450° Centigrade, respectively. The resultant film displayed a dark conductivity of $3.7 \times 10^{-5}$ Siemens/cm.

## Example 7 (Deposition From Dichlorosilane)

Dichlorosilane was utilized as a film precursor in the manner of Example 2 to produce an amorphous silicon-containing film at 560 °Centigrade in a 20 minute reaction. The film had a shiny golden appearance and displayed excellent adhesion to the glass substrate.

## Example 8 (Optical properties)

A film generated in the manner of Example 2 was examined for its optical absorption spectrum in the visible and near infrared wavelengths. A Tauc plot was used to determine an "optical" band gap of 1.55 eV. The absorption coefficient at 500 nm is $3 \times 10^5$ cm$^{-1}$.

## Example 9 (Limits of Film Formation)(Comparison Example)

Difluorosilane at a system pressure of 133.3 Pa (1.0 Torr) was flowed at a rate of 3 sccm over a Corning 7059 glass substrate heated to 525° Centigrade. No film was observed on the substrate after a reaction period of 60 minutes.

## Example 10 (Adhesion Test Following Salt Bath Immersion)

Difluorosilane was coated onto a piece of Corning 7059 glass in the manner of Example 2. The coated glass was immersed in 0.1M NaCl solution for three days at room temperature. The coated glass was then removed, patted dry, and the film was cross hatched with a razor blade. Cellophane Scotch brand tape was applied over the scored portion, pressed and then removed. The film did not demonstrate adhesive failure.

## Example 13 (Deposition On Ceramic Substrate)

Difluorosilane 6.67 kPa (50 Torr) was placed in a quartz demountable reactor along with two ceramic substrates, i.e., sapphire ($Al_2O_3$) and a thin plate of BeO. The reactor was then heated for 60 minutes at a temperature of 525 degrees Centigrade and then cooled to room temperature and attached to a vacuum line to remove the reaction by-products. The reactor was opened and the film-coated substrates removed.

## Claims

1. A method of forming an amorphous polymeric silicon-containing film on a substrate which method comprises: placing a substrate in a sealed decomposition vessel; evacuating air from the decomposition vessel; introducing a source gas at a pressure of 133.3 Pa to 66.7 kPa (1 to 500 Torr) into the decomposition vessel, the source gas consisting of dihalosilane or a mixture of dihalosilanes wherein each halogen of the dihalosilane or mixture of dihalosilanes is independently selected from fluorine, chlorine, bromine, and iodine; heating the substrate in the decomposition vessel to a temperature of 400 to 600°C to form, without glow or plasma discharge, an amorphous polymeric silicon-containing film on the substrate; and removing the substrate from the decomposition vessel.

2. A method according to claim 1, wherein the substrate is selected from glass, metal, ceramic material, and plastic.

3. A method according to claim 1 or 2, wherein the method further comprises the addition of a dopant to the decomposition vessel whereby the film formed on the substrate is doped by the dopant.

4. A method according to any of claims 1 to 4, wherein the source gas is difluorosilane.

5. A method according to any of claims 1 to 5, wherein the pressure of the source gas in the decomposition vessel is 2.67 to 66.7 kPa (20 to 500 Torr).

6. A method according to any of claims 1 to 5, wherein the pressure of the source gas in the decomposition vessel is 6.67 to 66.7 kPa (50 to 500 Torr).

7. A method according to any of claims 1 to 7, wherein the substrate in the decomposition vessel is heated to a temperature of 450 to 570°C.

## Patentansprüche

1. Verfahren zur Ausbildung eines amorphen, Silizium enthaltenden Polymerfilms auf einem Träger durch: Plazieren eines Trägers in einen abgedichteten Zersetzungsbehälter, Entfernen von Luft aus dem Zersetzungsbehälter, Einbringen eines Ausgangsgases bei einem Druck von 133,3 Pa bis 66,7 kPa (1-500 Torr) in den Zersetzungsbehälter, wobei das Ausgangsgas aus einem Dihalogensilan oder einer Mischung von Dihalogensilanen besteht, wobei jedes Halogen des Dihalogensilans oder der Mischung von Dihalogensilanen unabhängig voneinander aus Fluor, Chlor, Brom und Jod ausgewählt ist; Erwärmen des Trägers in dem Zersetzungsbehälter auf eine Temperatur von 400 bis 600°C, um ohne Glühen oder Plasmaentladung einen amorphen, Silizium enthaltenden Polymerfilm auf dem Träger auszubilden, und Entfernen des Trägers aus dem Zersetzungsbehälter.

2. Verfahren nach Anspruch 1,
**dadurch gekennzeichnet,**
daß der Träger aus Glas, Metall, keramischem Werkstoff und Kunststoff ausgewählt ist.

3. Verfahren nach Anspruch 1 oder 2,
**dadurch gekennzeichnet,**
daß das Verfahren zusätzlich die Zugabe eines Dotierungsmittels in den Zersetzungsbehälter beinhaltet, wobei der Film, der auf dem Träger ausgebildet wird, mit dem Dotierungsmittel dotiert wird.

4. Verfahren nach jedem der Ansprüche 1-3,
**dadurch gekennzeichnet,**
daß das Ausgangsgas Difluorsilan ist.

5. Verfahren nach jedem der Ansprüche 1-4,
**dadurch gekennzeichnet,**
daß der Druck des Ausgansgases in dem Zersetzungsbehälter zwischen 2,67 und 66,7 kPa (20-500 Torr) beträgt.

6. Verfahren nach jedem der Ansprüche 1-4,
**dadurch gekennzeichnet,**
daß der Druck des Ausgangsgases in dem Zersetzungsbehälter 6,67-66,7 kPa (50-500 Torr) beträgt.

7. Verfahren nach jedem der Ansprüche 1-6,
**dadurch gekennzeichnet,**
daß der Träger in dem Zersetzungsbehälter auf eine Temperatur von 450-570°C erwärmt wird.

**Revendications**

1. Procédé de formation d'une couche contenant du silicium polymère amorphe sur un substrat, lequel procédé comprend : la mise en place d'un substrat dans un récipient de décomposition fermé hermétiquement, l'évacuation de l'air du récipient de décomposition, l'introduction d'un gaz source à une pression de 133,3 Pa à 66,7 kPa (1 à 500 torrs) dans le récipient de décomposition, le gaz source étant formé d'un dihalogénosilane ou d'un mélange de dihalogénosilanes, chaque atome d'halogène du dihalogénosilane ou du mélange de dihalogénosilanes étant indépendamment choisi parmi les atomes de fluor, de chlore, de brome et d'iode, le chauffage du substrat, dans le récipient de décomposition, à une température de 400 à 600°C pour former, avec ou sans décharge luminescente ou de plasma, une couche contenant du silicium polymère amorphe sur le substrat, et le retrait du substrat du récipient de décomposition.

2. Procédé selon la revendication 1, où le substrat est choisi dans le groupe comprenant le verre, les métaux, les matériaux céramiques et les matières plastiques.

3. Procédé selon la revendication 1 ou 2, comprenant en outre l'addition d'un dopant dans le récipient de décomposition, grâce à quoi la couche formée sur le substrat est dopée par le dopant.

4. Procédé selon une quelconque des revendications 1 à 4, où le gaz source est un difluorosilane.

5. Procédé selon une quelconque des revendications 1 à 5, où la pression du gaz source est de 2,67 à 66,7 kPa (20 à 500 torrs) dans le récipient de décomposition.

6. Procédé selon une quelconque des revendications 1 à 5, où la pression du gaz source est de 6,67 à 66,7 kPa (50 à 500 torrs) dans le récipient de décomposition.

7. Procédé selon une quelconque des revendications 1 à 7, où le substrat est chauffé à une température de 450 à 570°C dans le récipient de décomposition.